# EUROPEAN PATENT APPLICATION

(11) **EP 4 718 721 A1**
(43) Date of publication of application: **01.04.2026**
(21) Application number: 25162493.8
(22) Date of filing: 10.03.2025
(51) Int. Cl.: H03K 3/012, H03K 3/356, H03K 3/013

(54) **FLIP-FLOPS WITH MULTIPLE DATA RETENTION PATHS**

(30) Priority: 27.09.2024 US 202418898813
(71) Applicant: GlobalFoundries U.S. Inc., Malta, NY 12020 (US)
(72) Inventor: Tran, Dzung T., Austin, 78735 (US); Saha, Uttam K., Santa Clara, 95054 (US); Jain, Navneet K., Santa Clara, 95054 (US); Siddiqi, Arif A., Santa Clara, 95054 (US); Kim, Byung S., Santa Clara, 95054 (US)
(74) Representative: Grünecker Patent- und Rechtsanwälte PartG mbB

(57) **Abstract**

A disclosed D flip-flop includes first and second stages. The first stage includes a first intermediate node. The second stage includes second and third intermediate nodes and a pair of transistors connected in series to the second intermediate node. The first and third intermediate nodes are connected to the gates of different ones of the transistors in the pair in order to provide feedforward and feedback paths for maintaining the voltage level of a signal on the second intermediate node when a clock signal is static and the second intermediate node is floating. Optionally, the second stage can also include a feedback loop (including an inverter and a multiphase clock-controlled tri-state logic device connected in series from and back to the third intermediate node) for maintaining the voltage level of a signal on the third intermediate node when the clock signal is static and the third intermediate node is floating.

## Description

### BACKGROUND

The present disclosure relates to flip-flop circuits and, more particularly, to embodiments of a low-power, reduced-area, flip-flop circuit suitable for both high and low frequency clock-controlled operation.

Various different types of circuit structures (e.g., memory circuits, counters, shift registers, etc.) employ data flip-flops. Data flip-flops are also known in the art as delay flip-flops, D-type flip-flops, or D flip-flops and are hereinafter referred to as D flip-flops. D flip-flops are circuits configured to receive a data input (D), to temporarily store the data, and to subsequently output a data output (Q) that reflects D and/or an inverted data output (Qb) that is inverted with respect to D. D flip-flop processing is controlled by a clock input (CK) and is typically edge triggered. For example, a D flip-flop may be configured so that Q switches to reflect the current value of D only when CK transitions from low to high. Thus, as CK transitions from low to high, Q will switch to reflect the current value D. As CK transitions back from high to low, Q should maintain the current value of D. D flip-flops are relatively large (e.g., include twenty-four transistors), consume a significant amount of power, and require the use of a constant frequency CK and plus multiple versions of CK (i.e., multiple phases of CK). Recently, D flip-flops have been developed that rely on a single phase CK and that are also smaller in area, faster and consume less power than conventional D flip-flops. However, these D flip-flops require CK to be dynamic (e.g., toggling at a constant frequency) to avoid loss of data. That is, if CK is static for some extended period of time, stored data may be lost.

### SUMMARY

Disclosed embodiments of a flip-flop can include a first stage and a second stage. The first stage can have a first intermediate node. The second stage can be connected to the first stage and can include a second intermediate node and a third intermediate node. The second stage can further include a pair of node-controlled transistors, which are connected in series between a voltage rail and the second intermediate node. The first intermediate node of the first stage and the third intermediate node of the second stage can be connected to gates of different ones of the node-controlled transistors in the pair.

More specifically, in some embodiments disclosed herein, a flip-flop can include a first stage and a second stage. The first stage can include a first intermediate node. The second stage can be connected to the first stage and can include a second intermediate node and a third intermediate node. The second stage can further include a pair of node-controlled transistors (e.g., P-type field effect transistors (PFETs)), which are connected in series between a positive voltage rail and the second intermediate node. The first intermediate node of the first stage and the third intermediate node of the second stage can be connected to gates of different ones of the node-controlled transistors in the pair.

In other embodiments disclosed herein, a flip-flop can include a first stage and a second stage. The first stage can include a first intermediate node. The second stage can be connected to the first stage and can include a second intermediate node and a third intermediate node. The second stage can further include a pair of node-controlled transistors (e.g., N-type field effect transistors (NFETs)), which are connected in series between the second intermediate node and a ground rail. The first intermediate node of the first stage and the third intermediate node of the second stage can be connected to gates of different ones of the node-controlled transistors in the pair.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1 is a schematic diagram illustrating a disclosed embodiment of a D flip-flop;
FIG. 2 is a table illustrating different possible states of nodes in the D flip-flop of FIG. 1 upon power up;
FIG. 3 is a table illustrating four examples A-D of possible states of nodes in the D flip-flop of FIG. 1 when a clock signal (CKM) is low and then goes high and further illustrating another four examples E-H of possible states of those nodes when CKM is high and then goes low;
FIG. 4 is a timing diagram illustrating operation of the D flip-flop of FIG. 1 using a high frequency CKM;
FIG. 5 is a timing diagram illustrating operation of the D flip-flop of FIG. 1 using a low frequency CKM; and
FIG. 6 is a schematic diagram illustrating another disclosed embodiment of a D flip-flop.

### DETAILED DESCRIPTION

As mentioned above, D flip-flops are circuits configured to receive a data input (D), to temporarily store the data, and to subsequently output a data output (Q) that reflects D and/or an inverted data output (Qb) that is inverted with respect to D. D flip-flop processing is controlled by a clock input (CK) and is typically edge triggered. For example, a D flip-flop may be configured so that Q switches to reflect the current value of D only when CK transitions from low to high. Thus, as CK transitions from low to high, Q will switch to reflect the current value D. As CK transitions back from high to low, Q should maintain the current value of D. D flip-flops are relatively large (e.g., include twenty-four transistors), consume a significant amount of power, and require the use of a constant frequency CK and plus multiple versions of CK (i.e., multiple phases of CK). Recently, D flip-flops have been developed that rely on a single phase CK and that are also smaller in area, faster and consume less power than conventional D flip-flops. However, these D flip-flops require CK to be dynamic (e.g., toggling at a constant frequency) to avoid loss of data. That is, if CK is static for some extended period of time, stored data may be lost.

In view of the foregoing, disclosed herein are embodiments of a D flip-flop, which is smaller in area, faster, and consumes less power than a conventional D flip-flop and which is further configured with a combination of data retentions paths (including a feedforward path, a feedback path, and a feedback loop) to avoid data loss if/when a clock signal that controls flip-flop operation is static for some extended period of time and a data input signal (D) changes states. More specifically, in the disclosed embodiments, the D flip-flop includes first and second stages. The first stage can include, among other components, a first intermediate node (also referred to herein as a pre-charge node). The second stage can be connected to the first stage and can include, among other components, a second intermediate node (also referred to herein as a data transfer node) and a third intermediate node (also referred to herein as a data retention node). The second stage can also include a pair of transistors, which are connected in series between the second intermediate node and either a positive voltage rail or a ground rail (depending upon the embodiment), and which are controlled by voltage levels of signals on the first and third intermediate nodes. That is, the first and third intermediate nodes can be connected to the gates of different ones of the transistors in the pair in order to provide both feedforward and feedback paths for maintaining the voltage level of the signal on the second intermediate node when a clock signal controlling flip-flop operation is static and the second intermediate node is floating.

Optionally, the second stage can also include a feedback loop (including an inverter and a multi-phase clock-controlled tri-state logic device connected in series from and back to the third intermediate node) for maintaining the voltage level of a signal on the third intermediate node when the clock signal is static and the third intermediate node is floating. It should be noted that in the disclosed embodiments, operation of the D flip-flop can be controlled by a single-phase clock signal, except in the feedback loop where the multiphase clock-controlled tri-state logic device is controlled by both clock and inverted clock signals, as discussed in greater detail below.

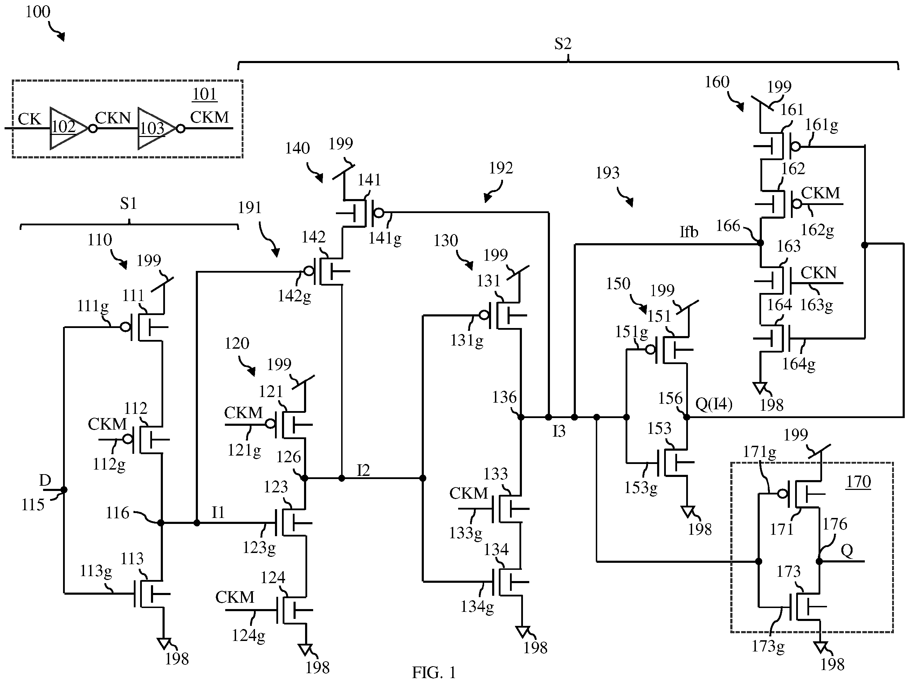

More particularly, FIG. 1 is a schematic diagram illustrating an embodiment of a D flip-flop 100. D flip-flop 100 can include a first stage (S1) (also referred to herein as an input stage or primary stage) and a second stage (S2) (also referred to herein as an output stage or secondary stage) connected to S1.

S1 can include a data input node 115, which is electrically connected to receive a data input (D). S1 can further include a first single phase clock-controlled tri-state logic device 110 (herein after referred to as first SPCTSL). For purposes of this disclosure, a single phase clock-controlled tri-state logic device is a tri-state logic device that outputs an output signal, which is high (i.e., logic 1, such as at VDD), low (i.e., logic 0, such as at ground or 0.0V), or floating depending on the states of a single clock signal and an input signal. A multiphase clock-controlled tri-state logic device is a tri-state logic device that outputs an output signal, which is high (i.e., logic 1), low (i.e., logic 0), or floating depending on the states of at least two clock signals (e.g., an clock signal and an inverted clock signal) and an input signal. First SPCTSL 110 can include a stack of first transistors including a first P-type field effect transistor (PFET) 111, an additional first PFET 112, and a first N-type field effect transistor (NFET) 113, which are electrically connected in series between a positive voltage rail 199 at a positive supply voltage (VDD) level and a ground rail 198 (e.g., at 0.0 volts (V)). In some embodiments, VDD can be 0.8V Alternatively, VDD could be at any other suitable positive supply voltage level (e.g., given the processing technology node at which the flip-flop is designed). Gate 111g of first PFET 111 and gate 113g of first NFET 113 can be electrically connected to data input node 115 to receive D. Gate 112g of additional first PFET 112 can be electrically connected to receive a clock signal (CKM) from a clock signal generator 101 (also referred to herein as a clock generation circuit), as discussed in greater detail below. First SPCTSL 110 can further include a first intermediate node 116 at the junction between additional first PFET 112 and first NFET 113 (i.e., at the electrical connection between additional first PFET 112 and first NFET 113). A first intermediate signal (I1) can be output at first intermediate node 116. The state of I1 can be high, low, or floating depending upon the states of D and CKM.

S2 can include a second single phase clock-controlled tri-state logic device 120 (hereinafter referred to as second SPCTSL). Second SPCTSL 120 can include a stack of second transistors including a second PFET 121, a second NFET 123, and an additional second NFET 124, which are electrically connected in series between positive voltage rail 199 and ground rail 198. Gate 121g of second PFET 121 and gate 124g of additional second NFET 124 can be electrically connected to receive CKM. Gate 123g of second NFET 123 can be electrically connected to first intermediate node 116 to receive I1. Second SPCTSL 120 can further include a second intermediate node 126 at the junction between second PFET 121 and second NFET 123 (i.e., at the electrical connection between second PFET 121 and second NFET 123). A second intermediate signal (I2) can be output at second intermediate node 126 and the state of I2 can be high, low, or floating depending upon the states of I1 and CKM.

S2 can further include a third single phase clock-controlled tri-state logic device 130 (hereinafter referred to as third SPCTSL). Third SPCTSL 130 can include a third PFET 131, a third NFET 133, and an additional third NFET 134, which are electrically connected in series between positive voltage rail 199 and ground rail 198. Gate 131g of third PFET 131 and gate 134g of additional third NFET 134 can be electrically connected to second intermediate node 126 to receive I2. Gate 133g of third NFET 133 can be electrically connected to receive CKM. Third SPCTSL 130 can further include a third intermediate node 136 at the junction between third PFET 131 and third NFET 133 (i.e., at the electrical connection between third PFET 131 and third NFET 133). A third intermediate signal (I3) can be output at third intermediate node 136 and the state of I3 can be high, low, or floating depending upon the states of I2 and CKM.

S2 can further include a stack 140 of fourth transistors. Stack 140 can include a fourth PFET 141 and an additional fourth PFET 142, which are electrically connected in series between positive voltage rail 199 and second intermediate node 126. Gate 141g of fourth PFET 141 can be electrically connected to third intermediate node 136 to receive I3, thereby creating a feedback path 192 from third intermediate node 136 to fourth PFET 141 to assist in maintaining a high voltage level on second intermediate node 126 when necessary. Furthermore, gate 142g of additional fourth PFET 142 can be electrically connected to first intermediate node 116 to receive I1, thereby creating a feedforward path 191 from first intermediate node 116 to additional fourth PFET 142 to further assist in maintaining a high voltage level on second intermediate node 126 when necessary. For example, given the feedback path 192 and feedforward path 191 mentioned above, when I1 and I3 are both at low volage levels, fourth PFET 141 and additional fourth PFET 142 will both be on (i.e., conductive) to keep the voltage level on I2 high if second intermediate node 126 is floating, as discussed in greater detail below.

S2 can further include an inverter 150 and a multiphase clock-controlled tri-state logic device 160 (hereinafter referred to as MPCTSL), which are electrically connected in series with third intermediate node 136 and further arranged in a loop back to third intermediate node 136 (as discussed in greater detail below) and/or an additional inverter 170, which is also electrically connected in series with third intermediate node 136.

Specifically, S2 can include an inverter 150. Inverter 150 can include a fifth PFET 151 and a fifth NFET 153, which are electrically connected in series between positive voltage rail 199 and ground rail 198. A gate 151g of fifth PFET 151 and a gate 153g of fifth NFET 153 can each be electrically connected to third intermediate node 136 to receive I3. Inverter 150 can further include a node 156 (which is a data output node or a fourth intermediate node) at the junction between fifth PFET 151 and fifth NFET 153 (i.e., at the electrical connection between fifth PFET 151 and fifth NFET 153). The output signal of inverter 150 at node 156 can be either the data output signal (Q) of D flip-flop 100 in the absence of an additional inverter 170 or a fourth intermediate signal (I4) when additional inverter 170 is included in D flip-flop 100 for generating Q (as discussed below). In any case, Q (or I4, which has the same state as Q) will be low when I3 is high and vice versa. MPCTSL 160 can include a stack of sixth transistors including a sixth PFET 161, an additional sixth PFET 162, a sixth NFET 163, and an additional sixth NFET 164, which are electrically connected in series between positive voltage rail 199 and ground rail 198. Gate 161g of sixth PFET 161 and gate 164g of additional sixth NFET 164 can be electrically connected to node 156 to receive Q (or I4). Furthermore, gate 162g of additional sixth PFET 162 can be electrically connected to receive CKM, whereas gate 163g of sixth NFET 163 can be electrically connected to receive an inverted clock signal (CKN). CKN can be inverted relative to CKM and, particularly, can has the same properties in terms of frequency, etc., but in an opposite polarity relative to CKM. MPCTSL 160 can further include a sixth intermediate node 166 at the junction between additional sixth PFET 162 and sixth NFET 163 (i.e., at the electrical connection between additional sixth PFET 162 and sixth NFET 163). A feedback signal (Ifb) can be output at sixth intermediate node 166 and the state of Ifb can be high, low, or floating depending upon the states of Q (or I4), CKM and CKN. Sixth intermediate node 166 can be electrically connected to back to third intermediate node 136, thereby forming a feedback loop 193 for maintaining I3 either high or low when CKM is low and CKN is high.

Additional inverter 170 can include a seventh PFET 171 and a seventh NFET 173, which are electrically connected in series between positive voltage rail 199 and ground rail 198. Gate 171g of seventh PFET 171 and gate 173g of seventh NFET 173 can each be electrically connected to third intermediate node 136 to receive I3. Additional inverter 170 can further include a data output node 176 at the junction between seventh PFET 171 and seventh NFET 173 (i.e., at the electrical connection between seventh PFET 171 and seventh NFET 173). A data output signal (Q) can be output at data output node 176 and the state of Q will be the same as I4. Specifically, Q will depend upon the state of I3 (i.e., when I3 is high, Q will be low and vice versa).

Thus, in D flip-flop 100 described above and illustrated in FIG. 1, operation is primarily controlled by one clock signal (i.e., CKM) and only operation of feedback loop 193 is controlled by two clock signals (i.e., CKM and CKN). CKM and CKN can be generated by a clock signal generator 101. Clock signal generator 101 can, for example, include a pair of series-connected inverters 102 and 103. Inverter 102 can be connected to receive a system clock signal (CK) and can invert CK to output CKN. Inverter 103 can be connected to receive CKN and can invert CKN to output CKM. Thus, CKN is inverted relative to both CK and CKM. Since D flip-flop 100 only requires CKM and CKN to operate, clock signal generator 101 is relatively small. That is, it has fewer inverters and/or delay buffers than clock signal generators used for other D flip-flops that require more than two different clock phases to operate. Additionally, since there are a relatively small number of transistors in D flip-flop 100 controlled by these clock signals (e.g., only one transistor controlled by CKN and only five transistor controlled by CKM), clock driver size can be reduced.

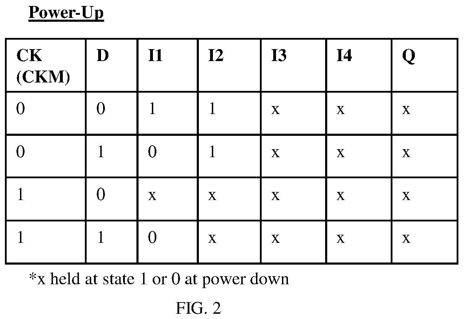

FIG. 2 is a table illustrating different possible states of nodes with D flip-flop 100 upon power up. Referring to FIG. 1 in combination with FIG. 2, if CKM and D are both low at power up, then first PFET 111 will be on, first NFET 113 will be off, and additional first PFET 112 will be on. Thus, I1 at first intermediate node 116 will be pulled up. When I1 is high, second NFET 123 will turn on. However, since CKM is low, additional second NFET 124 will be off and, thus, will prevent the voltage level on second intermediate node 126 from being pulled down. Additionally, second PFET 121 will be turned on and will pull up the voltage level on second intermediate node 126 so I2 will be high. When I2 is high, third PFET 131 will be off and will prevent the voltage level on third intermediate node I3 from being pulled up. Furthermore, when I2 is high, additional third NFET 134 will be on. However, since CKM is low, third NFET 133 will be off and will prevent the voltage level on third intermediate node 136 from being pulled down. Thus, the voltage level at third intermediate node 136 will be floating and I3 should maintain the same state as it had at power down, as indicated by an 'x' in the table of FIG. 2. Since I3 maintains the same state it had at power down, so will Q (I4).

If CKM is low and D is high at power up, then additional first PFET 112 will be on, but first PFET 111 will be off and will prevent the voltage level on first intermediate node 116 from being pulled up. Additionally, first NFET 113 will be on, pulling down the voltage level on first intermediate node 116. Thus, I1 will be low. When I1 is low and CKM is also low, second PFET 121 will turn on and pull up the voltage level on second intermediate node 126. When I2 is high and CKM is low, third intermediate node 136 will be floating. So, as discussed above, I3 and Q (I4) should maintain the states (high or low) that they had before power down.

If CKM is high and D is low at power up, then first PFET 111 will be on, but additional first PFET 112 will be off and will prevent the voltage level on first intermediate node 116 from being pulled up. Additionally, first NFET 113 will be off and will prevent the voltage level on first intermediate node 116 from being pulled down. Thus, first intermediate node 116, second intermediate node 126, and third intermediate node 136 will all be floating and I1, I2, I3 and Q (I4) will maintain the states (high or low) that they had before power down.

If CKM is high and D is also high at power up, then first PFET 111 and additional first PFET 112 will both be off and will prevent the voltage level on first intermediate node 116 from being pulled up. First NFET 113 will be on and will pull the voltage level on first intermediate node 116 down to ground. When CKM is high and I1 is low, second PFET 121 will be off and will prevent the voltage level on the second intermediate node 126 from being pulled up. Additionally, additional second NFET 124 will be on because CKM is high. However, second NFET 123 will be off because I1 is low and will prevent the voltage level on second intermediate node 126 from being pulled down. Thus, second intermediate node 126 will be floating and I2, I3 and Q (I4) will maintain the states (high or low) that they had before power down.

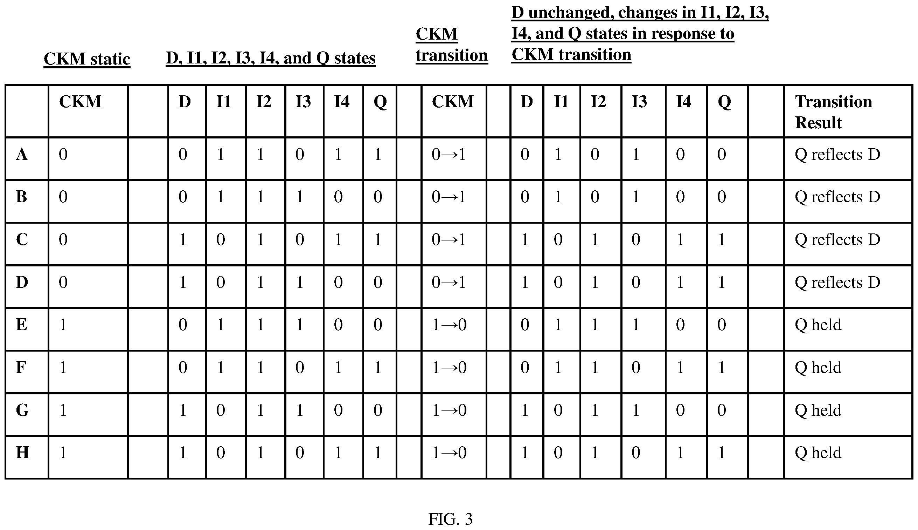

FIG. 3 is a table illustrating four examples A-D of multiple possible states of D and I1-Q when CKM is low and how those states change when CKM transitions from low to high and further illustrating another four examples E-H of possible states of D and I1-Q when CKM is high and how those states will change when CKM transitions from high to low.

As illustrated in examples A-D, Q (I4) will either remain unchanged or will change so that it is the same as D during any transition of CKM from low to high. For example, in example A, if CKM and D are currently low and I1 is high, I2 is high, I3 is low, and Q is high, transitioning of CKM from low to high (i.e., the rising edge of CKM) will cause I1 to stay high, I2 to go low, I3 to go high, and Q to go low. Thus, Q changes to reflect the same state as D. In example B, if CKM and D are currently low, and I1 is high, I2 is high, I3 is high, and Q is low, transitioning of CKM from low to high will cause I1 to stay high, I2 to go low, I3 to stay high, and Q to stay low. Thus, Q remains unchanged to reflect the same state as D. In example C, if CKM is currently low and D is currently high and if I1 is low, I2 is high, I3 is low, and Q is high, transitioning of CKM from low to high will cause I1 to stay low, I2 to stay high, I3 to stay low, and Q to stay high. Thus, Q remains unchanged to reflect the same state as D. In example D, if CKM is currently low and D is high, and if I1 is low, I2 is high, I3 is high, and Q is low, transitioning of CKM from low to high will cause I1 to stay low, I2 to stay high, I3 to go low, and Q to go high. Thus, Q changes to reflect the same state as D.

As illustrated in examples E-H, when CKM transitions from high to low Q (I4) remains unchanged regardless of the state of D. In example E, if CKM is currently high and D is currently low and I1, I2 and I3 are high and Q is low, transitioning of CKM from high to low (i.e., the falling edge of CKM) will not cause changes in any of these nodes (i.e., I1, I2, and I3 will stay high and Q will stay low). Thus, Q is held. In example F, if CKM is currently high and D is currently low and I1 and I2 are high, I3 is low and Q is high, transitioning of CKM from high to low will again not cause changes in any of these nodes (i.e., I1 and I2 stay high, I3 stays low and Q stays high). Thus, Q is held. In example G, if CKM and D are both currently high and if I1 is low, I2 and I3 are high, and Q is low, transitioning of CKM from high to low will again not cause changes in any of these nodes (i.e., I1 stays low, I2 and I3 stay high, and Q stays low). Thus, Q is held. In example H, if CKM and D are both currently high, and if I1 is low, I2 is high, I3 is low, and Q is high, transitioning of CKM from high to low will again not cause changes in any of these nodes (i.e., I1 stays low, I2 stays high, I3 stays low, and Q stays high). Thus, Q is held.

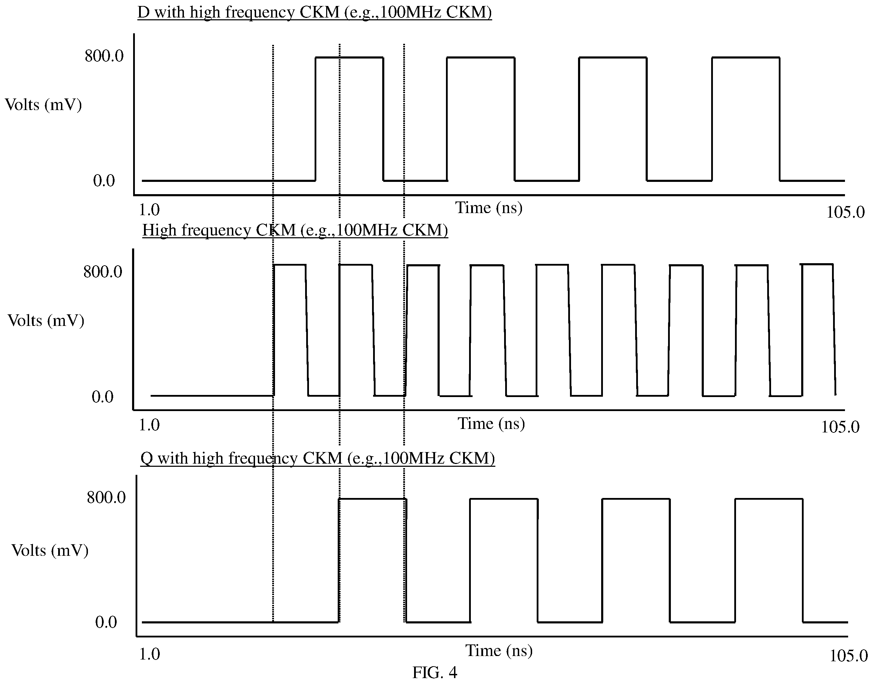

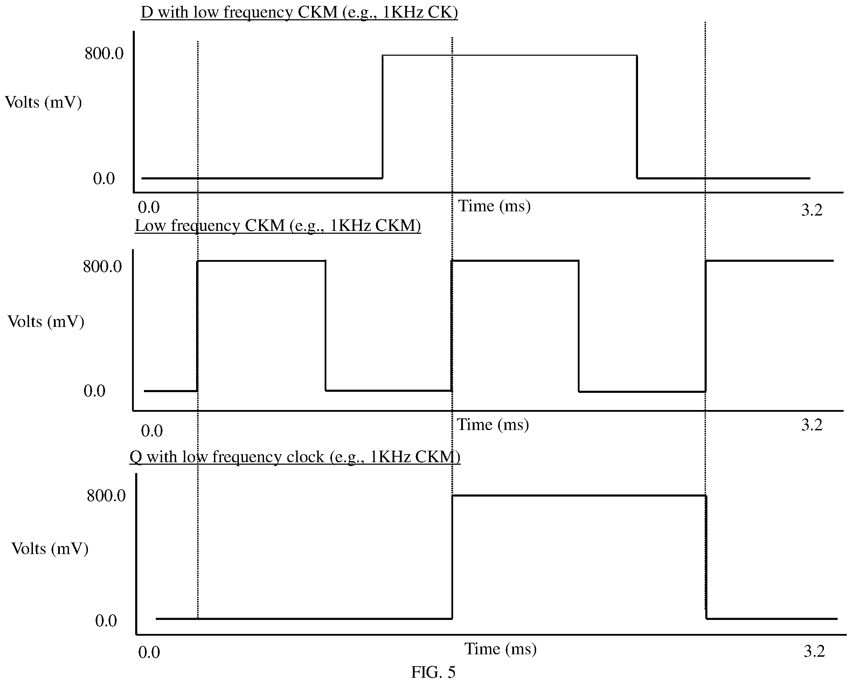

FIG. 4 is a timing diagram illustrating that, for D flip-flop 100 of FIG. 1, changes in Q reflect changes in D only at the rising edges of a high frequency CKM (e.g., a 100MHz CKM). FIG. 5 is a timing diagram illustrating that, for D flip-flop 100 of FIG. 1, changes in Q similarly reflect changes in D at the rising edges of a low frequency CKM (e.g., a 1KHz CKM). It should be noted that in D flip-flop 100 of FIG. 1, the combination of feedforward path 191, feedback path 192, and feedback loop 193 effectively prevent data loss if/when CKM is static for some extended period of time (i.e., in the absence of clock edges for a prolonged period) by ensuring that I2 and I3 retain their current states if/when second intermediate node 126 and/or 136, respectively, are floating. Thus, the combination of feedforward path 191, feedback path 192, and feedback loop 193 ensure that Q in FIG. 5 only switches on the rising edge of CKM.

For example, as mentioned above, third intermediate node 136 is also referred to herein as a data retention node. Feedback loop 193 ensures that I3 does not change states when third intermediate node 136 is floating. Specifically, when D goes or is high and CKM is low, I1 on first intermediate node 116 will be low. When I1 is low and CKM is low, second PFET 121 will be on and both second NFET 123 and additional second NFET 124 will be off. Therefore, I2 on second intermediate node 126 will go high. If I2 on second intermediate node 126 is high and CKM is low, third intermediate node 136 is floating and I3 is maintained in its current state by feedback loop 193. For example, if I3 is high it will remain high. This is because Q (I4) is low and, within MPCTSL 160, when Q (I4) is low, CKM is low, and CKN is high, additional sixth PFET 162 and sixth PFET 161 will both be on and additional sixth NFET 164 will be off. Thus, Ifb on sixth intermediate node 166 will be pulled up by additional sixth PFET 162 and sixth PFET 161 and will, in turn, pull up I3 on third intermediate node 136. Contrarily, if I3 is low, it will remain low. This is because Q (I4) is high and, within MPCTSL 160, when Q (I4) is high, CKM is low, and CKN is high, sixth PFET 161 will be off and sixth NFET 163 and additional sixth NFET 164 will be on. Thus, Ifb on sixth intermediate node 166 will be pulled down through sixth NFET 163 and additional sixth NFET 164 and will, in turn pull down I3 on third intermediate node 136.

When D goes or is low and CKM is low, first PFET 111 and additional first PFET 112 will be on and first NFET 113 will be off. Therefore, I1 on first intermediate node 116 will go high. If I1 is high and CKM is low, then second PFET 121 and second NFET 123 will both be on but additional second NFET 124 will be off. Therefore, second PFET 121 can pull the voltage level on the second intermediate node 126 up and the additional second NFET 124 will prevent the voltage level thereon from being pulled down. So, regardless of whether I1 is high or low, when CKM is low, I2 on second intermediate node 126 will be high. As mentioned above, if I2 on second intermediate node 126 is high and CKM is low, third intermediate node 136 would be floating and I3 would be kept in its current state (high or low) by feedback loop 193, in the same manner as described above. It should be noted that feedback loop 193 will be off (i.e., sixth intermediate node 166 will be floating) when CKM is high and CKN is low.

Also, as mentioned above, second intermediate node 126 is also referred to herein as a data transfer node. Feedforward path 191 and feedback path 192 ensure that I2 does not change states under certain conditions and, particularly, when CKM transitions from low to high and D is high. For example, as mentioned above, when CKM is low, I2 on second intermediate node 126 will be high regardless of the state of I1 and third intermediate node 136 will be floating, so I3 may be low and Q may be the same as D (as in example C in the table of FIG. 3) or I3 may be high and Q may be different than D (as in example D in the table of FIG. 3).. If CKM goes high when D is high, then first NFET 113 will remain on and continue to pull down the voltage level on first intermediate node 116. Thus, I1 on first intermediate node 116 will be low. As a result, second PFET 121 and second NFET 123 will both be off, so second intermediate node 126 will be floating. So, to ensure that I2 stays high when I3 is low in order to prevent I3 from changing states and, more particularly, to ensure that Q stays high to reflect D, fourth PFET 141 and additional fourth PFET 142 of feedforward path 191 and feedback path 192 will both turn on to pull up the voltage level on second intermediate node 126 and ensure I2 stays high.

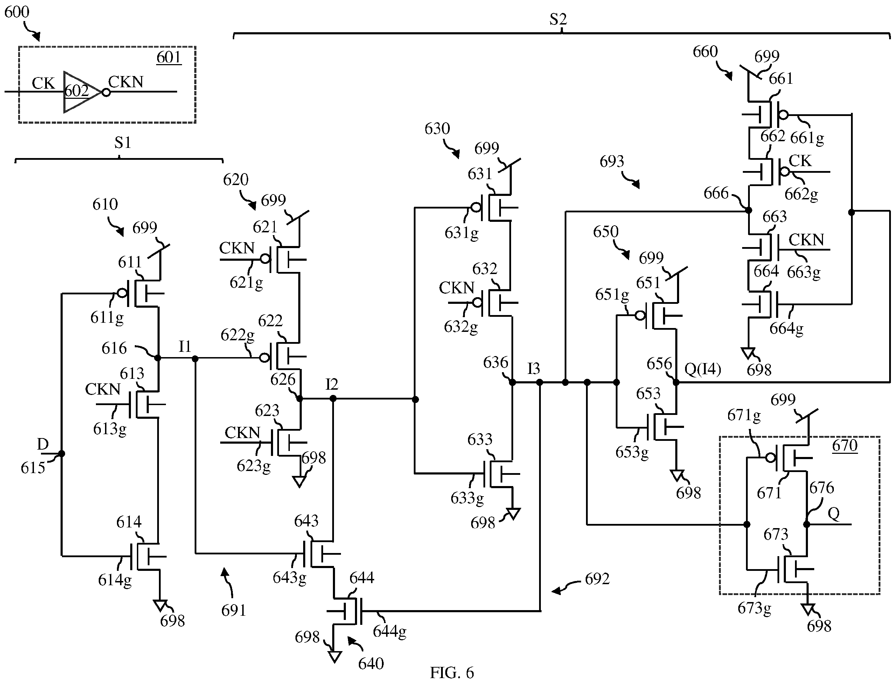

FIG. 6 is a schematic diagram illustrating an alternative embodiment of a D flip-flop 600. D flip-flop 600 is similar to D flip-flop 100 with minor variations including, but not limited to, the fact that the stack 640 of fourth transistors are NFETs instead of PFETs. Specifically, referring to FIG. 6, D flip-flop 600 can include a first stage (S1) (also referred to herein as an input stage or primary stage) and a second stage (S2) (also referred to herein as an output stage or secondary stage) connected to S1.

S1 can include a data input node 615, which is electrically connected to receive a data input (D). S1 can further include a first single phase clock-controlled tri-state logic device 610 (herein after referred to as first SPCTSL). As mentioned above, a single phase clock-controlled tri-state logic device is a tri-state logic device that outputs an output signal, which is high (i.e., logic 1, such as at VDD), low (i.e., logic 0, such as at ground or 0.0V), or floating and which depends on the states of a single clock signal and an input signal. A multiphase clock-controlled tri-state logic device is a tri-state logic device that outputs an output signal, which is high (i.e., logic 1), low (i.e., logic 0), or floating and which depends on the states of at least two clock signals (e.g., an clock signal and an inverted clock signal) and an input signal. First SPCTSL 610 can include a stack of first transistors including a first PFET 611, a first NFET 613, and an additional first NFET 614, which are electrically connected in series between a positive voltage rail 699 at a positive supply voltage (VDD) level and a ground rail 698 (e.g., at 0.0 volts (V)). In some embodiments, VDD can be 0.8V Alternatively, VDD could be at any other suitable positive supply voltage level (e.g., given the processing technology node at which the flip-flop is designed). Gate 611g of first PFET 611 and gate 614g of additional first NFET 614 can be electrically connected to data input node 615 to receive D. Gate 613g of first NFET 613 can be electrically connected to receive a clock signal (CKN) from a clock signal generator 601 (also referred to herein as a clock generation circuit), as discussed in greater detail below. First SPCTSL 610 can further include a first intermediate node 616 at the junction between first PFET 611 and first NFET 613 (i.e., at the electrical connection between first PFET 611 and first NFET 613). A first intermediate signal (I1) can be output at first intermediate node 616. The state of I1 can be high, low, or floating depending upon the states of D and CKN.

S2 can include a second single phase clock-controlled tri-state logic device 620 (hereinafter referred to as second SPCTSL). Second SPCTSL 620 can include a stack of second transistors including a second PFET 621, an additional second PFET 622, and a second NFET 623, which are electrically connected in series between positive voltage rail 699 and ground rail 698. Gate 621g of second PFET 621 and gate 623g of second NFET 623 can be electrically connected to receive CKN. Gate 622g of additional second PFET 622 can be electrically connected to first intermediate node 616 to receive I1. Second SPCTSL 620 can further include a second intermediate node 626 at the junction between additional second PFET 622 and second NFET 623 (i.e., at the electrical connection between additional second PFET 622 and second NFET 623). A second intermediate signal (I2) can be output at second intermediate node 626 and the state of I2 can be high, low, or floating depending upon the states of I1 and CKN.

S2 can further include a third single phase clock-controlled tri-state logic device 630 (hereinafter referred to as third SPCTSL). Third SPCTSL 630 can include a third PFET 631, an additional third PFET 632, and a third NFET 633, which are electrically connected in series between positive voltage rail 699 and ground rail 698. Gate 631g of third PFET 631 and gate 633g of third NFET 633 can be electrically connected to second intermediate node 626 to receive I2. Gate 632g of additional third PFET 632 can be electrically connected to receive CKN. Third SPCTSL 630 can further include a third intermediate node 636 at the junction between additional third PFET 632 and third NFET 633 (i.e., at the electrical connection between additional third PFET 632 and third NFET 633). A third intermediate signal (I3) can be output at third intermediate node 636 and the state of I3 can be high, low, or floating depending upon the states of I2 and CKN.

S2 can further include a stack 640 of fourth transistors. Stack 640 can include a fourth NFET 643 and an additional fourth NFET 644, which are electrically connected in series between second intermediate node 626 and ground rail 698. Gate 644g of additional fourth NFET 644 can be electrically connected to third intermediate node 636 to receive I3, thereby creating a feedback path 692 from third intermediate node 636 to additional fourth NFET 644 to assist in maintaining a low voltage level on second intermediate node 626 when necessary. Furthermore, gate 643g of fourth NFET 643 can be electrically connected to first intermediate node 616 to receive I1, thereby creating a feedforward path 691 from first intermediate node 616 to fourth NFET 643 to further assist in maintaining a low voltage level on second intermediate node 626 when necessary. For example, given the feedback path 692 and feedforward path 691 mentioned above, when I1 and I3 are both at high volage levels, fourth NFET 643 and additional fourth NFET 644 will both be on (i.e., conductive) to keep the voltage level on I2 low if second intermediate node 626 is floating.

S2 can further include an inverter 650 and a multiphase clock-controlled tri-state logic device 660 (hereinafter referred to as MPCTSL), which are electrically connected in series with third intermediate node 636 and arranged in a loop back to third intermediate node 636 (as discussed in greater detail below) and/or an additional inverter 670, which is also electrically connected in series with third intermediate node 636. Specifically, S2 can include an inverter 650. Inverter 650 can include a fifth PFET 651 and a fifth NFET 653, which are electrically connected in series between positive voltage rail 699 and ground rail 698. A gate 651g of fifth PFET 651 and a gate 653g of fifth NFET 653 can each be electrically connected to third intermediate node 636 to receive I3. Inverter 650 can further include a node 656 at the junction between fifth PFET 651 and fifth NFET 653 (i.e., at the electrical connection between fifth PFET 651 and fifth NFET 653). The output signal of inverter 650 at node 656 can be either the data output signal (Q) of D flip-flop 600 in the absence of an additional inverter 670 or a fourth intermediate signal (I4) if additional inverter 670 is included in D flip-flop 600 for generating Q (as discussed below). In any case, Q (or I4, which has the same state as Q) will be low when I3 is high and vice versa. MPCTSL 660 can include a stack of sixth transistors including a sixth PFET 661, an additional sixth PFET 662, a sixth NFET 663, and an additional sixth NFET 664, which are electrically connected in series between positive voltage rail 699 and ground rail 698. Gate 661g of sixth PFET 661 and gate 664g of additional sixth NFET 664 can be electrically connected to node 656 to receive Q (or I4). Furthermore, gate 662g of additional sixth PFET 662 can be electrically connected to receive CK, whereas gate 663g of sixth NFET 663 can be electrically connected to receive another clock signal (CK). CKN can be inverted relative to CK and, particularly, can has the same properties in terms of frequency, etc., but in an opposite polarity relative to CK. MPCTSL 660 can further include a sixth intermediate node 666 at the junction between additional sixth PFET 662 and sixth NFET 663 (i.e., at the electrical connection between additional sixth PFET 662 and sixth NFET 663). A feedback signal (Ifb) can be output at sixth intermediate node 666 and the state of Ifb can be high, low, or floating depending upon the states of Q (or I4), CK and CKN. Sixth intermediate node 666 can be electrically connected back to third intermediate node 636, thereby forming a feedback loop 693 for maintaining I3 either high or low when CK is low and CKN is high.

Additional inverter 670 can include a seventh PFET 671 and a seventh NFET 673, which are electrically connected in series between positive voltage rail 699 and ground rail 698. Gate 671g of seventh PFET 671 and gate 673g of seventh NFET 673 can each be electrically connected to third intermediate node 636 to receive I3. Additional inverter 670 can further include a data output node 676 at the junction between seventh PFET 671 and seventh NFET 673 (i.e., at the electrical connection between seventh PFET 671 and seventh NFET 673). A data output signal (Q) can be output at data output node 676 and the state of Q will be the same as I4. Specifically, it will depend upon the state of I3 (i.e., when I3 is high, Q will be low and vice versa).

Thus, in D flip-flop 600 described above and illustrated in FIG. 6, operation is primarily controlled by one clock signal (i.e., CKN) and only operation of feedback loop 693 is controlled by two clock signals (i.e., CK and CKN). CKN can be generated by a clock signal generator 601. Clock signal generator 601 can, for example, include a single inverter 602. Inverter 602 can be connected to receive CK (e.g., a system clock signal) and can invert CK to output CKN. Since D flip-flop 600 only requires CK and CKN to operate, clock signal generator 601 is relatively small. That is, it doesn't need as many inverters and/or delay buffers than clock signal generators used for other D flip-flops that require more than two different clock phases to operation. Additionally, since there are a relatively small number of transistors in D flip-flop 600 controlled by these clock signals (e.g., only one transistor controlled by CK and only five transistors controlled by CKN), clock driver size can be reduced.

It should be understood that D flip-flop 600 operates similarly to D flip-flop 100 of FIG. 1. That is, when CKN transitions from low to high, Q (I4) will either change or stay the same so as to reflect D. However, when CKN transitions from high to low, Q will be held in the same state, regardless of the state of D. Furthermore, in D flip-flop 600 of FIG. 6, the combination of feedforward path 691, feedback path 692, and feedback loop 693 effectively prevent data loss if/when CKN is static for some extended period of time (i.e., in the absence of clock edges for a prolonged period) by ensuring that I2 and I3 retain their current states if/when second intermediate node 626 and/or 636, respectively, are floating. Thus, the combination of feedforward path 691, feedback path 692 and feedback loop 693 ensure that Q only switches on the rising edge of CKN.

It should be understood that in the embodiments described above a field effect transistor (FET) is a semiconductor device including a channel region between source/drain regions, a primary gate (also referred to in the art as a front gate) adjacent to the channel region, and, optionally, a secondary gate (also referred to in the art as a back gate) adjacent to the channel region opposite the primary gate. A P-type FET (PFET) can include P-type source/drain regions at a relatively high conductivity level (e.g., P+ source/drain regions) and a channel region that is either an intrinsic (i.e., undoped) channel region or an N-type channel region at a relatively low conductivity level (e.g., a N- channel region). An N-type FET (NFET) can include N-type source/drain regions at a relatively high conductivity level (e.g., N+ source/drain regions) and a channel region that is either an intrinsic (i.e., undoped) channel region or a P-type channel region at a relatively low conductivity level (e.g., a P- channel region). Various different types of FET structures are known in the art and could be incorporated into the disclosed circuit structures. For example, the FETs mentioned above could be bulk semiconductor devices or semiconductor-on-insulator devices, planar semiconductor devices or non-planar semiconductor devices, single gate devices or dual-gate devices, single gate finger devices or multiple gate finger devices, etc.

In some embodiments, the FETs of the disclosed D flip-flop 100 of FIG. 1 or 600 of FIG. 6 could be formed using an advanced semiconductor-on-insulator technology processing platform such that they are either fully-depleted semiconductor-on-insulator FETs (e.g., a fully-depleted SOI (FDSOI) FET) or partially-depleted semiconductor-on-insulator FETs (e.g., a partially-depleted SOI (PDSOI) FET). Those skilled in the art will recognize that one advantage of advanced semiconductor-on-insulator technology processing platforms is that FETs can be formed on an insulator layer above a particular type of well region (e.g., an N-type well region (Nwell) or a P-type well region (Pwell)) in order to achieve different types of NFETs or PFETs with different threshold voltages (VTs). For example, for a super low threshold voltage (SLVT) or low threshold voltage (LVT) FET, an NFET can be formed above an Nwell and a PFET can be formed above a Pwell. For a regular threshold voltage (RVT) or high threshold voltage (HVT) FET, an NFET can be formed above a Pwell and a PFET can be formed above an Nwell. Whether the FETs are SLVT or LVT FETs or whether they are RVT or HVT FETs will depend upon the design (e.g., device size, etc.) and process specifications (e.g., dopant concentrations, etc.). In some embodiments, the FETs within D flip-flop 100 of FIG. 1 or D flip-flop 600 of FIG. 6 can be all RVT or HVT FETs. That is, with D flip-flop 100, 600, PFETs can be above Nwells and NFETs can be above Pwells.

It should be understood that in the method and structures described above, a semiconductor material refers to a material whose conducting properties can be altered by doping with an impurity. Example semiconductor materials include, but are not limited to, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a D flip-flop including first and second stages is disclosed. In various embodiments as disclosed herein, the first stage includes a first intermediate node. The second stage includes second and third intermediate nodes and a pair of transistors connected in series to the second intermediate node. The first and third intermediate nodes are connected to the gates of different ones of the transistors in the pair in order to provide feedforward and feedback paths for maintaining the voltage level of a signal on the second intermediate node when a clock signal is static and the second intermediate node is floating. Optionally, the second stage can also include a feedback loop (including an inverter and a multiphase clock-controlled tri-state logic device connected in series from and back to the third intermediate node) for maintaining the voltage level of a signal on the third intermediate node when the clock signal is static and the third intermediate node is floating.

The following embodiments are explicitly disclosed.

### Embodiment 1:

A flip-flop comprising:
a first stage having a first intermediate node; and
a second stage connected to the first stage and including:
   a second intermediate node;
   a third intermediate node; and
   a pair of node-controlled transistors connected in series between a voltage rail and the second intermediate node, wherein the first intermediate node and the third intermediate node are connected to gates of different ones of the node-controlled transistors in the pair.

In some illustrative examples of embodiment 1, the voltage rail may be a positive voltage rail. Herein, the pair of node-controlled transistors is connected in series between a positive voltage rail and the second intermediate node.

In some illustrative examples of embodiment 1, the voltage rail may be a ground rail. Herein, the pair of node-controlled transistors may be connected in series between the second intermediate node and a ground rail.

### Embodiment 2:

The flip-flop of embodiment 1, wherein the second stage further includes:
an inverter; and
a multiphase clock-controlled tri-state logic device, wherein the inverter is connected in series between the third intermediate node and the multiphase clock-controlled tri-state logic device and the multiphase clock-controlled tri-state logic device is connected in series between the inverter and the third intermediate node.

### Embodiment 3:

The flip-flop of embodiment 2,
wherein the multiphase clock-controlled tri-state logic device includes a P-type field effect transistor (PFET), an additional PFET, an N-type field effect transistor (NFET), and an additional NFET connected in series between a positive voltage rail and a ground rail,
wherein gates of the PFET and the additional NFET are connected to the inverter, and
wherein gates of the additional PFET and the NFET are connected to receive a clock signal and an inverted clock signal, respectively.

### Embodiment 4:

The flip-flop of embodiment 3,
wherein the inverter includes a data output node, and
wherein the data output node is connected to the gates of the PFET and the additional NFET of the multiphase clock-controlled tri-state logic device.

### Embodiment 5:

The flip-flop of embodiment 3 or 4,
wherein the inverter includes a fourth intermediate node,
wherein the fourth intermediate node is connected to the gates of the PFET and the additional NFET of the multiphase clock-controlled tri-state logic device, and
wherein the flip-flop further comprises an additional inverter connected to the third intermediate node and having a data output node.

### Embodiment 6:

A flip-flop comprising:
a first stage having a first intermediate node; and
a second stage connected to the first stage and including:
   a second intermediate node;
   a third intermediate node; and
   a pair of node-controlled transistors connected in series between a positive voltage rail and the second intermediate node, wherein the first intermediate node and the third intermediate node are connected to gates of different ones of the node-controlled transistors in the pair.

Embodiment 6 may depend on embodiment 1 according to the illustrative examples of embodiment 1 according to which the voltage rail in embodiment 1 may be a positive voltage rail. Accordingly, embodiment 6 may be combined with any of embodiments 2 to 5.

### Embodiment 7:

The flip-flop of embodiment 6,
wherein the first stage includes a first P-type field effect transistor (PFET), an additional first PFET, and a first N-type field effect transistor (NFET) connected in series between the positive voltage rail and a ground rail,
wherein the first intermediate node is at a junction between the additional first PFET and the first NFET,
wherein gates of the first PFET and the first NFET are connected to a data input node,
   and
wherein a gate of the additional first PFET is connected to receive a clock signal.

### Embodiment 8:

The flip-flop of embodiment 7,
wherein the second stage includes:
   a second PFET, a second NFET, and an additional second NFET connected in series between the positive voltage rail and the ground rail,
      wherein the second intermediate node is at a junction between the second PFET and the second NFET,
      wherein a gate of the second NFET is connected to the first intermediate node, and
      wherein gates of the second PFET and the additional second NFET are connected to receive the clock signal; and
   a third PFET, a third NFET, and an additional third NFET connected in series between the positive voltage rail and the ground rail,
      wherein the third intermediate node is at a junction between the third PFET and the third NFET,
      wherein gates of the third PFET and the additional third NFET are connected to the second intermediate node, and
      wherein a gate of the third NFET is connected to receive the clock signal, and
wherein the node-controlled transistors in the pair include a fourth PFET and an additional fourth PFET.

### Embodiment 9:

The flip-flop of embodiment 8, wherein the second stage further includes:
an inverter; and
a multiphase clock-controlled tri-state logic device, wherein the inverter is connected in series between the third intermediate node and the multiphase clock-controlled tri-state logic device and the multiphase clock-controlled tri-state logic device is connected in series between the inverter and the third intermediate node.

### Embodiment 10:

The flip-flop of embodiment 9,
wherein the inverter includes a fifth PFET and a fifth NFET connected in series between the positive voltage rail and the ground rail,
wherein gates of the fifth PFET and the fifth NFET are connected to the third intermediate node,
wherein the multiphase clock-controlled tri-state logic device includes a sixth PFET, an additional sixth PFET, a sixth NFET, and an additional sixth NFET connected in series between the positive voltage rail and the ground rail,
wherein gates of the sixth PFET and the additional sixth NFET are connected to a node at a junction between the fifth PFET and the fifth NFET, and
wherein gates of the additional sixth PFET and the sixth NFET are connected to receive the clock signal and an inverted clock signal, respectively.

### Embodiment 11:

The flip-flop of embodiment 10, wherein the node between the fifth PFET and the fifth NFET is a data output node.

### Embodiment 12:

The flip-flop of embodiment 10,
wherein the node between the fifth PFET and the fifth NFET is another intermediate node, and
wherein the flip-flop further comprises an additional inverter connected to the third intermediate node and having a data output node.

### Embodiment 13:

The flip-flop of embodiment 10, further comprising a clock signal generator, wherein the clock signal generator includes a first inverter and a second inverter connected in series, wherein the first inverter receives a system clock signal and outputs the inverted clock signal and wherein the second inverter receives the inverted clock signal and outputs the clock signal.

### Embodiment 14:

A flip-flop comprising:
a first stage having a first intermediate node; and
a second stage connected to the first stage and including:
   a second intermediate node;
   a third intermediate node; and
   a pair of node-controlled transistors connected in series between the second intermediate node and a ground rail, wherein the first intermediate node and the third intermediate node are connected to gates of different ones of the node-controlled transistors in the pair.

Embodiment 14 may depend on embodiment 1 according to the illustrative examples of embodiment 1 according to which the voltage rail in embodiment 1 may be a ground rail. Accordingly, embodiment 14 may be combined with any of embodiments 2 to 5. Furthermore, any of the features as specified in any of embodiments 7 to 13 as such may be combined with embodiment 14 without combination with embodiment 6.

### Embodiment 15:

The flip-flop of embodiment 14,
wherein the first stage includes a first P-type field effect transistor (PFET), a first N-type field effect transistor (NFET), and an additional first NFET connected in series between a positive voltage rail and the ground rail,
wherein the first intermediate node is at a junction between the first PFET and the first NFET,
wherein gates of the first PFET and the additional first NFET are connected to a data input node, and
wherein a gate of the first NFET is connected to receive an inverted clock signal.

### Embodiment 16:

The flip-flop of embodiment 15,
wherein the second stage includes:
   a second PFET, an additional second PFET and a second NFET connected in series between the positive voltage rail and the ground rail,
      wherein the second intermediate node is at a junction between the additional second PFET and the second NFET,
      wherein a gate of the additional second PFET is connected to the first intermediate node, and
      wherein gates of the second PFET and the second NFET are connected to receive the inverted clock signal; and
   a third PFET, an additional third PFET, and a third NFET connected in series between the positive voltage rail and the ground rail,
      wherein the third intermediate node is at a junction between the additional third PFET and the third NFET,
      wherein gates of the third PFET and the third NFET are connected to the second intermediate node, and
      wherein a gate of the additional third PFET is connected to receive the inverted clock signal, and
wherein the node-controlled transistors in the pair include a fourth NFET and an additional fourth NFET.

### Embodiment 17:

The flip-flop of embodiment 16, wherein the second stage further includes:
an inverter; and
a multiphase clock-controlled tri-state logic device,
wherein the inverter is connected in series between the third intermediate node and the multiphase clock-controlled tri-state logic device and the multiphase clock-controlled tri-state logic device is connected in series between the inverter and the third intermediate node,
wherein the inverter includes a fifth PFET and a fifth NFET connected in series between the positive voltage rail and the ground rail,
wherein gates of the fifth PFET and the fifth NFET are connected to the third intermediate node,
wherein the multiphase clock-controlled tri-state logic device includes a sixth PFET, an additional sixth PFET, a sixth NFET, and an additional sixth NFET connected in series between the positive voltage rail and the ground rail,
wherein gates of the sixth PFET and the additional sixth NFET are connected to a node at a junction between the fifth PFET and the fifth NFET, and
wherein gates of the additional sixth PFET and the sixth NFET are connected to receive a clock signal and the inverted clock signal, respectively.

### Embodiment 18:

The flip-flop of embodiment 17, wherein the node between the fifth PFET and the fifth NFET is a data output node.

### Embodiment 19:

The flip-flop of embodiment 17 or 18,
wherein the node between the fifth PFET and the fifth NFET is another intermediate node, and
wherein the flip-flop further comprises an additional inverter connected to the third intermediate node and having a data output node.

### Embodiment 20:

The flip-flop of one of embodiments 17 to 19, further comprising a clock signal generator, wherein the clock signal generator receives the clock signal and outputs the inverted clock signal.

Any of embodiments 1 to 20 may be a D-flip-flop in illustrative examples.

## Claims

1. A flip-flop comprising:
a first stage having a first intermediate node; and
a second stage connected to the first stage and including:
a second intermediate node;
a third intermediate node; and
a pair of node-controlled transistors connected in series between a voltage rail and the second intermediate node, wherein the first intermediate node and the third intermediate node are connected to gates of different ones of the node-controlled transistors in the pair.

2. The flip-flop of claim 1, wherein the second stage further includes:
an inverter; and
a multiphase clock-controlled tri-state logic device, wherein the inverter is connected in series between the third intermediate node and the multiphase clock-controlled tri-state logic device and the multiphase clock-controlled tri-state logic device is connected in series between the inverter and the third intermediate node.

3. The flip-flop of claim 2,
wherein the multiphase clock-controlled tri-state logic device includes a P-type field effect transistor (PFET), an additional PFET, an N-type field effect transistor (NFET), and an additional NFET connected in series between a positive voltage rail and a ground rail,
wherein gates of the PFET and the additional NFET are connected to the inverter, and
wherein gates of the additional PFET and the NFET are connected to receive a clock signal and an inverted clock signal, respectively.

4. The flip-flop of claim 3,
wherein the inverter includes a data output node, the data output node being connected to the gates of the PFET and the additional NFET of the multiphase clock-controlled tri-state logic device, and/or
wherein the inverter includes a fourth intermediate node, the fourth intermediate node being connected to the gates of the PFET and the additional NFET of the multiphase clock-controlled tri-state logic device, and the flip-flop further comprising an additional inverter connected to the third intermediate node and having a data output node.

5. The flip-flop of one of claims 1 to 4, wherein the pair of node-controlled transistors is connected in series between a positive voltage rail and the second intermediate node.

6. The flip-flop of claim 5,
wherein the first stage includes a first P-type field effect transistor (PFET), an additional first PFET, and a first N-type field effect transistor (NFET) connected in series between the positive voltage rail and a ground rail,
wherein the first intermediate node is at a junction between the additional first PFET and the first NFET,
wherein gates of the first PFET and the first NFET are connected to a data input node, and
wherein a gate of the additional first PFET is connected to receive a clock signal.

7. The flip-flop of claim 6,
wherein the second stage includes:
a second PFET, a second NFET, and an additional second NFET connected in series between the positive voltage rail and the ground rail,
wherein the second intermediate node is at a junction between the second PFET and the second NFET,
wherein a gate of the second NFET is connected to the first intermediate node, and
wherein gates of the second PFET and the additional second NFET are connected to receive the clock signal; and
a third PFET, a third NFET, and an additional third NFET connected in series between the positive voltage rail and the ground rail,
wherein the third intermediate node is at a junction between the third PFET and the third NFET,
wherein gates of the third PFET and the additional third NFET are connected to the second intermediate node, and
wherein a gate of the third NFET is connected to receive the clock signal, and
wherein the node-controlled transistors in the pair include a fourth PFET and an additional fourth PFET.

8. The flip-flop of claim 7 in combination with claim 2,
wherein the inverter includes a fifth PFET and a fifth NFET connected in series between the positive voltage rail and the ground rail,
wherein gates of the fifth PFET and the fifth NFET are connected to the third intermediate node,
wherein the multiphase clock-controlled tri-state logic device includes a sixth PFET, an additional sixth PFET, a sixth NFET, and an additional sixth NFET connected in series between the positive voltage rail and the ground rail,
wherein gates of the sixth PFET and the additional sixth NFET are connected to a node at a junction between the fifth PFET and the fifth NFET, and
wherein gates of the additional sixth PFET and the sixth NFET are connected to receive the clock signal and an inverted clock signal, respectively.

9. The flip-flop of claim 8, wherein the node between the fifth PFET and the fifth NFET is a data output node, and/or
wherein the node between the fifth PFET and the fifth NFET is another intermediate node, the flip-flop further comprising an additional inverter connected to the third intermediate node and having a data output node, and/or
wherein the flip-flop further comprises a clock signal generator, the clock signal generator including a first inverter and a second inverter connected in series, the first inverter receiving a system clock signal and outputting the inverted clock signal, and the second inverter receiving the inverted clock signal and outputting the clock signal.

10. The flip-flop of one of claims 1 to 9, wherein the pair of node-controlled transistors is connected in series between the second intermediate node and a ground rail.

11. The flip-flop of claim 10,
wherein the first stage includes a first P-type field effect transistor (PFET), a first N-type field effect transistor (NFET), and an additional first NFET connected in series between a positive voltage rail and the ground rail,
wherein the first intermediate node is at a junction between the first PFET and the first NFET,
wherein gates of the first PFET and the additional first NFET are connected to a data input node, and
wherein a gate of the first NFET is connected to receive an inverted clock signal.

12. The flip-flop of claim 11,
wherein the second stage includes:
a second PFET, an additional second PFET and a second NFET connected in series between the positive voltage rail and the ground rail,
wherein the second intermediate node is at a junction between the additional second PFET and the second NFET,
wherein a gate of the additional second PFET is connected to the first intermediate node, and
wherein gates of the second PFET and the second NFET are connected to receive the inverted clock signal; and
a third PFET, an additional third PFET, and a third NFET connected in series between the positive voltage rail and the ground rail,
wherein the third intermediate node is at a junction between the additional third PFET and the third NFET,
wherein gates of the third PFET and the third NFET are connected to the second intermediate node, and
wherein a gate of the additional third PFET is connected to receive the
inverted clock signal, and
wherein the node-controlled transistors in the pair include a fourth NFET and an additional fourth NFET.

13. The flip-flop of claim 12, wherein the second stage further includes:
an inverter; and
a multiphase clock-controlled tri-state logic device,
wherein the inverter is connected in series between the third intermediate node and the multiphase clock-controlled tri-state logic device and the multiphase clock-controlled tri-state logic device is connected in series between the inverter and the third intermediate node,
wherein the inverter includes a fifth PFET and a fifth NFET connected in series between the positive voltage rail and the ground rail,
wherein gates of the fifth PFET and the fifth NFET are connected to the third intermediate node,
wherein the multiphase clock-controlled tri-state logic device includes a sixth PFET, an additional sixth PFET, a sixth NFET, and an additional sixth NFET connected in series between the positive voltage rail and the ground rail,
wherein gates of the sixth PFET and the additional sixth NFET are connected to a node at a junction between the fifth PFET and the fifth NFET, and
wherein gates of the additional sixth PFET and the sixth NFET are connected to receive a clock signal and the inverted clock signal, respectively.

14. The flip-flop of claim 13, wherein the node between the fifth PFET and the fifth NFET is a data output node, and/or
wherein the flip-flop further comprises a clock signal generator, the clock signal generator receiving the clock signal and outputting the inverted clock signal.

15. The flip-flop of claim 13 or 14,
wherein the node between the fifth PFET and the fifth NFET is another intermediate node, and
wherein the flip-flop further comprises an additional inverter connected to the third intermediate node and having a data output node.
